# EUROPÄISCHE PATENTANMELDUNG

(11) **EP 4 566 892 A1**
(43) Veröffentlichungstag der Anmeldung: **11.06.2025**
(21) Anmeldenummer: 24307049.7
(22) Anmeldetag: 06.12.2024
(51) Int. Cl.: B60R 16/02, H02G 5/06, H02G 3/06, H05K 9/00

(54) **ELEKTROMAGNETISCHE ABSCHIRMUNG EINER ANTRIEBSSTRANG- STROMSCHIENE UND VERFAHREN ZUR HERSTELLUNG EINER ELEKTROMAGNETISCH ABGESCHIRMTEN ANTRIEBSSTRANG-STROMSCHIENE**

(30) Priorität: 07.12.2023 DE 102023134365
(71) Anmelder: Nexans, 92400 Courbevoie (FR)
(72) Erfinder: MAYER, Udo, 92400 COURBEVOIE (FR); DÖLLINGER, Ulrich, 92400 COURBEVOIE (FR); STEINBERG, Helmut, 92400 COURBEVOIE (FR)
(74) Vertreter: Ipsilon

(57) **Zusammenfassung**

Eine elektromagnetische Abschirmung einer starren, formstabilen Antriebsstrang-Stromschiene (10) eines Elektro- oder Hybridfahrzeugs umfasst zumindest ein ein- oder mehrteiliges, an die Form bzw. Kontur der Antriebsstrang-Stromschiene (10) angepasstes Abschirmelement (20, 30). Das zumindest eine Abschirmelement (20, 30) weist eine elektrisch leitfähige Schicht auf und ist auf einer zu der Antriebsstrang-Stromschiene (10) weisenden Seite elektrisch nichtleitend, mit einer elektrisch isolierenden Schicht versehen, oder zur Aufnahme einer elektrisch isolierenden Schicht eingerichtet. Das ein- oder mehrteilige Abschirmelement (20,30) weist mindestens eine verschließbare Trennstelle (22) auf, an welcher ein Zugang zu einem von dem ein- oder mehrteiligen Abschirmelement (20, 30) umschlossenen Raum ermöglicht ist, um das Abschirmelement (20, 30) um die Antriebsstrang-Stromschiene (10) herum anzuordnen.

## Beschreibung

### FELD

Die vorliegende Erfindung betrifft abgeschirmte Hochleistungssammelschienen zum Laden von Elektrofahrzeugen und zur Energieverteilung in diesen.

### HINTERGRUND

Herkömmliche Fahrzeugverkabelungen umfassen eine Vielzahl von Kabeln zur Übertragung von Strom- oder Datensignalen. Diese herkömmlichen Fahrzeugverkabelungen sind nicht in der Lage, den gestiegenen Anforderungen an die Verteilung hoher Leistungen insbesondere in Elektrofahrzeugen gerecht zu werden. Darüber hinaus besteht ein ständiger Bedarf an der Verbesserung der Kabeldesigns, um hohe Leistungen von über mehreren hundert Kilowatt zu bewältigen. Herkömmliche Fahrzeugverkabelungen bieten keine robuste, stabile und abgeschirmte Unterstützung für das Aufladen und die Energieverteilung in Elektrofahrzeugen. Außerdem steigen die Komplexität und die Kosten herkömmlicher Kabel mit zunehmender Anzahl elektronischer Module. Darüber hinaus können Fehler in Drähten oder Leitern großer Kabelbaugruppen schwer zu identifizieren und kostspielig zu reparieren sein.

In Elektrofahrzeugen kommen daher zunehmend Hochleistungssammelschienen zum Einsatz, die aus einem soliden Leiter bestehen, der in eine zur Montage am Einbauort im Elektrofahrzeug geeignete Form gebracht wurde, bspw. durch Biegen oder Pressformen. Die Antriebe von Elektrofahrzeugen werden in der Regel über Hochleistungsumrichter angesteuert. Die Hochleistungsumrichter arbeiten mit hochfrequenten Strömen, die elektromagnetische Felder erzeugen, die Störungen in benachbarten Bauteilen hervorrufen können. Deshalb ist eine entsprechende Abschirmung der Sammelschienen erforderlich. Durch das Umformen der Sammelschiene kann es zu großen Veränderungen der Abmessungen und Radien der Sammelschiene kommen. Außerdem wirken während des Umformens große Kräfte auf das Bauteil. Wegen der Gefahr der Beschädigung der elektromagnetischen Abschirmung beim Umformen wird diese daher erst nach dem Umformen an der Sammelschiene angebracht. Ein solcher Prozess ist in der WO2021188438A1 gezeigt. Hier wird eine in Form gebrachte Stromschiene nachträglich mit einer Abschirmung gegen elektromagnetische Interferenz (EMI) umhüllt. Dazu wird ein handelsüblicher EMI-Schlauch verwendet, welcher über die umgeformte Sammelschiene gezogen und anschließend in einer Pressform an die Stromschiene angepresst wird. Es ist leicht erkennbar, dass je nach Flexibilität des EMI-Schlauchs relativ viel überschüssiges Material verformt werden muss, um eng an der Kontur der Sammelschiene anzuliegen, damit der in Fahrzeugen generell knapp bemessene Platz nicht durch eine voluminöse Abschirmung beansprucht wird. Zudem muss der EMI-Schlauch seine Form behalten, damit er sich nicht lockert und an der Sammelschiene, benachbarten Bauteilen oder Karosserieteilen scheuert, was über die Zeit zu Lücken in der EMI-Abschirmung führen kann. Bei dem bekannten Verfahren muss außerdem eine Pressform verwendet werden, die exakt an die Kontur der Sammelschiene angepasst ist.

Eine Alternative zu dem bekannten Verfahren stellt EMI-Schrumpfschlauch dar. Hierbei kann die Massekontaktierung eine Herausforderung darstellen, und die erforderliche elektrische Isolierung gegenüber der Sammelschiene. Gegebenenfalls ist die Sammelschiene vor der Montage des EMI-Schrumpfschlauchs mit geeigneten Mitteln elektrisch zu isolieren. Bei Sammelschienen mit vielen Biegungen mit engen Radien kann die Anbringung sowohl der elektrischen Isolierung als auch des EMI-Schrumpfschlauchs schwierig sein. Da das Schrumpfungsverhältnis üblicherweise nicht mehr als 3:1 beträgt, kann der Durchmesser des Schrumpfschlauchs oft nicht so groß gewählt werden, dass ein Aufschieben auf die Sammelschiene vereinfacht ist, insbesondere dann, wenn die Sammelschiene in eine komplexe Form gebracht wurde. Außerdem wird für die Schrumpfung des EMI-Schrumpfschlauchs ein erheblicher Wärmeeintrag benötigt, der unter Umständen die elektrische Isolierung der Sammelschiene beeinträchtigen kann.

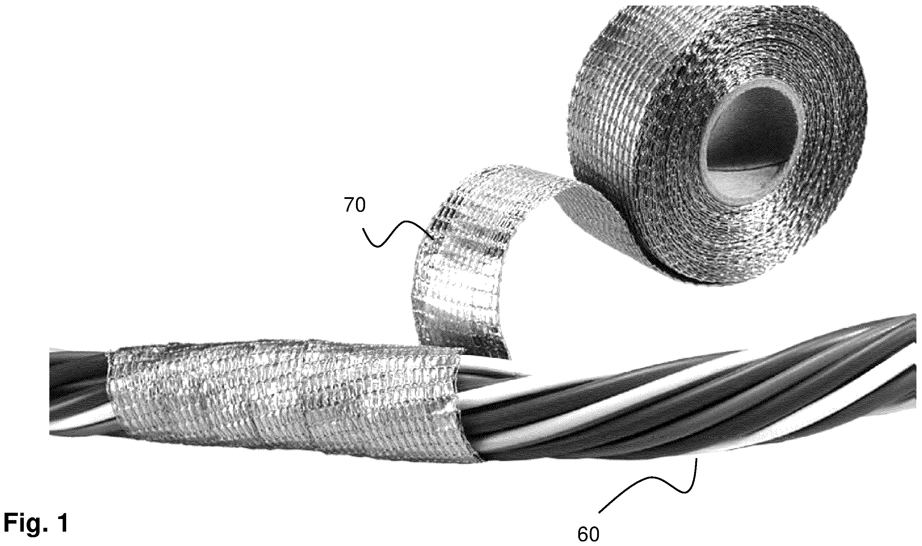

Eine weitere bekannte Alternative besteht darin, die Sammelschiene in ihrer endgültigen Form mit einem EMI-Band zu umwickeln. Diese Alternative ist exemplarisch in Figur 1 gezeigt, wo ein Bündel 60 aus Einzelleitern mit einem EMI-Band 70 umwickelt wird. Da die Einzelleiter jeweils eine eigene elektrische Isolierung aufweisen, muss das EMI-Band lediglich derart elektrisch leitend ausgeführt sein, dass überlappende Bereiche eine durchgängige elektrische Schicht bilden. Auch bei dieser Art der elektromagnetischen Abschirmung kann die Massekontaktierung eine Herausforderung darstellen. Gleiches gilt für die erforderliche elektrische Isolierung gegenüber einer nicht elektrisch isolierten Sammelschiene. Gegebenenfalls muss zuerst eine Isolierschicht um die Sammelschiene gewickelt werden, und anschließend das EMI-Band. Diese Alternative ist vergleichsweise aufwendig und, wenn überhaupt, nur schwer automatisierbar. Sie dürfte daher eher für Einzelstücke oder Kleinserien in Frage kommen.

Es besteht daher ein Bedarf an einem Verfahren zur Herstellung von elektromagnetisch abgeschirmten Sammelschienen, welches sich insbesondere für die Herstellung großer Stückzahlen eignet, an entsprechenden, zur Verwendung in dem Verfahren verwendbaren Stromschienen und elektromagnetischen Abschirmungen und Verfahren zu deren Herstellung.

### BESCHREIBUNG DER ERFINDUNG

Diese Aufgabe wird durch die in Anspruch 1 angegebene elektromagnetische Abschirmung und das in Anspruch 7 angegebene Verfahren zur Herstellung einer elektromagnetisch abgeschirmten Stromschiene gelöst. Ausgestaltungen und Weiterentwicklungen der Abschirmung bzw. der Verfahren sind in den jeweiligen abhängigen Ansprüchen angegeben.

Eine elektromagnetische Abschirmung einer starren, formstabilen Antriebsstrang-Stromschiene eines Elektro- oder Hybridfahrzeugs gemäß einem ersten Aspekt der Erfindung umfasst zumindest ein ein- oder mehrteiliges, an die Form bzw. Kontur der Antriebsstrang-Stromschiene angepasstes Abschirmelement. Das zumindest eine Abschirmelement ist auf einer zu der Antriebsstrang-Stromschiene weisenden Seite elektrisch nichtleitend, mit einer elektrisch isolierenden Schicht versehen, oder zur Aufnahme einer elektrisch isolierenden Schicht eingerichtet. Das zumindest eine Abschirmelement kann bspw. aus einem elektrisch isolierenden Material bestehen, welches an einer von der Antriebsstrang-Stromschiene fortweisenden Seite mit einer elektrisch leitenden Schicht versehen ist, bspw. durch Kleben. Diese Schicht kann ihrerseits mit einer Isolierschicht umgeben sein. Es ist auch denkbar, dass die elektrisch leitende Schicht in das Material des Abschirmelements eingeschlossen ist, bspw. Umspritzt ist. In einer anderen Ausgestaltung, bei der das zumindest eine Abschirmelement an einer von der Antriebsstrang-Stromschiene fortweisenden Seite mit einer elektrisch isolierenden Schicht versehen ist, kann das Abschirmelement aus einem elektrisch leitenden Material bestehen, bspw. einem elektrisch leitfähigen Polymer oder einem mit leitfähigen Partikeln versetzten nichtleitenden Material, und die elektrisch isolierende Schicht ist mit dem Material des Abschirmelements bspw. durch Kleben oder über formschlüssig kooperierende Elemente verbunden. Es ist aber auch denkbar, die elektrisch isolierende Schicht in einem geeigneten Spritzverfahren direkt mit dem Abschirmelement zu verbinden. Das erfindungsgemäße Abschirmelement weist außerdem mindestens eine verschließbare, vorzugsweise wieder zu öffnende und wiederverschließbare Trennstelle auf, an welcher ein Zugang zu einem von dem ein- oder mehrteiligen Abschirmelement umschlossenen Raum ermöglicht ist, um das Abschirmelement um die Antriebsstrang-Stromschiene herum anzuordnen. Die Trennstelle ist vorzugsweise so eingerichtet, dass die beiderseits der Trennstelle liegenden Teile des Abschirmelements elektrisch leitend miteinander verbindbar sind, so dass sich eine geschlossene Abschirmung ergibt. Das geschlossene Abschirmelement bildet bspw. einen Hohlkörper, der an elektrischen Kontaktstellen zur elektrischen Verbindung der Stromschiene Öffnungen aufweist.

Elektrisch leitende Schichten in der elektromagnetischen Abschirmung können vollständig geschlossen sein, oder aus einem leitfähigen Geflecht oder Gewebe bestehen, dessen Maschen oder Poren kleiner sind als die abzuschirmenden Wellenlängen.

Bei einer oder mehreren Ausführungen der elektromagnetischen Abschirmung weist zumindest ein Abschirmelement zumindest an einem Ende entlang der Kontur der von der Abschirmung umschlossenen Antriebsstrang-Stromschiene eine erste Kontur auf, welche zur formschlüssigen Aufnahme einer zu der ersten Kontur komplementären zweiten Kontur eines weiteren Abschirmelements eingerichtet ist, und welche außerdem dazu eingerichtet ist, eine elektrisch leitfähige Verbindung zwischen den beiden Abschirmelementen herzustellen. Die erste und die zweite Kontur sind dabei dazu eingerichtet, bei verschlossenen Trennstellen der ersten und zweiten Abschirmelemente ineinanderzugreifen und die Abschirmelemente mechanisch miteinander zu verbinden. Das geschlossene Abschirmelement bildet bspw. einen aus mehreren Segmenten bestehenden Hohlkörper, der an elektrischen Kontaktstellen zur elektrischen Verbindung der Stromschiene Öffnungen aufweist.

Bei einer oder mehreren Ausführungen der elektromagnetischen Abschirmung ist eine mit der Abschirmung fest verbundene oder darin integrierte elektrische Kontaktstelle vorgesehen, welche zur Kontaktierung der Abschirmung mit einem Masse- oder Erdpotential eingerichtet ist. Die Kontaktstelle kann bspw. eine mit einer elektrisch leitfähigen Schicht der Abschirmung leitend verbundene Lasche umfassen, oder eine Klemm- oder Schraubverbindung mit der elektrisch leitfähigen Schicht bereitstellen.

Bei einer oder mehreren Ausführungen der elektromagnetischen Abschirmung sind an der mindestens einen verschließbaren Trennstelle zusammenwirkende Verbindungselemente vorgesehen, welche die Trennstelle im verschlossenen Zustand halten. Diese Verbindungselemente können bspw. mit der Abschirmung verbundene Rastverbindungen umfassen, oder zur Aufnahme von anderen Verbindungsmitteln eingerichtete Konturen, etwa Schraublöcher oder mittels Klemmen verbindbare Laschen.

In einer bevorzugten Ausgestaltung umfasst die elektromagnetische Abschirmung an die Form der Antriebsstrang-Stromschiene angepasste Formteile, welche zu einer geschlossenen elektromagnetischen Abschirmung zusammengesetzt werden können. Je nach Form der Antriebsstrang-Stromschiene können die Formteile einteilig sein, bspw. über ein Filmscharnier miteinander verbundene Halbschalen, welche die Antriebsstrang-Stromschiene im geschlossenen Zustand umschließen, oder mehrteilig. Mehrteilige Formteile können genutzt werden, wenn die Form der Stromschiene keine günstige Anbringung von Gelenken oder Scharnieren zulässt, oder wenn die Form der Antriebsstrang-Stromschiene nicht mit zwei Halbschalen komplett umschlossen werden kann. In letzterem Fall kann die Antriebsstrang-Stromschiene abschnittsweise umschlossen werden, wobei die elektrisch leitenden Schirmschichten benachbarter Abschnitte mittels geeigneter Koppelstrukturen leitend miteinander verbunden sind.

Im Falle von als Halbschalen ausgestalteten elektromagnetischen Abschirmungen können die Halbschalen mittels Rastverbindungen miteinander verbunden werden. Diese Rastverbindungen können elektrisch leitfähig sein, und/oder die aneinander liegenden Kanten der Halbschalen stellen eine elektrisch leitfähige Verbindung zueinander her. Anstelle von Halbschalen können je nach der Komplexität der Form der Antriebsstrang-Stromschiene auch drei- oder mehrteilige Schalen verwendet werden.

Die erfindungsgemäße elektromagnetische Abschirmung bietet die Möglichkeit, die Erdungsanschlüsse an den Einbauort angepasst in das Design einzubeziehen. Dies erleichtert die Montage, so dass hier keine Kabelstücke oder andere Verbinder mehr erforderlich sind. Auch die zusätzliche Fixierung der Antriebsstrang-Stromschiene am Einbauort, insbesondere bei längeren Bauteilen, kann in die elektromagnetische Abschirmung integriert sein. Dabei können zusätzliche Befestigungsstrukturen als zusätzlicher Erdungspunkt oder elektrisch isoliert ausgeführt sein.

Die erfindungsgemäße elektromagnetische Abschirmung ist zumindest in Teilen einfacher automatisiert herstellbar als die herkömmliche Umwicklung mit einem Abschirmband, zumindest aber vereinfacht sie die zur Fertigstellung auszuführenden Schritte erheblich.

Ein Verfahren zur Herstellung einer elektromagnetischen Antriebsstrang-Stromschiene eines Elektro- oder Hybridfahrzeugs gemäß einem ersten Aspekt der Erfindung umfasst das Bereitstellen einer in ihrer Form an deren Einbauort angepassten Stromschiene, und das Bereitstellen eines oder mehrerer Teile einer in der Gesamtheit der Teile in zumindest einer Dimension an die der Stromschiene angepassten elektromagnetischen Abschirmung. Die zumindest eine Dimension ist vorzugsweise eine Erstreckung der Stromschiene zwischen zwei an jeweiligen Enden angeordneten elektrischen Kontakten, in der Regel eine Längserstreckung. Das Verfahren umfasst ferner das Anordnen der Stromschiene in der Abschirmung und das Verschließen der Trennstelle.

Die ein oder mehreren Teile der elektromagnetischen Abschirmung sind vorzugsweise auf der zu der Stromschiene weisenden Seite oder Fläche elektrisch isoliert. Ist dies nicht der Fall, und ist auch die Antriebsstrang-Stromschiene selbst nicht elektrisch isoliert, umfasst das Verfahren außerdem einen Schritt des Umhüllens der Stromschiene mit einer an dieser eng anliegenden elektrischen Isolierung. Diese elektrische Isolierung kann neben den bekannten Umhüllungen mit elektrisch isolierenden Natur- oder Kunststoffen auch durch Beschichten der Oberfläche mit geeigneten Lacken erreicht werden, wobei gerade letzteres Verfahren leicht in Verfahren zur Herstellung großer Stückzahlen eingliederbar ist. Hier ist bspw. eine Tauchlackierung denkbar, durch welche auf einfache Weise eine ausreichend dicke Isolierschicht herstellbar ist. Alternativ dazu kann das Verfahren das Anbringen einer elektrischen Isolierung auf der zu der Antriebsstrang-Stromschiene weisenden Seite oder Oberfläche der elektromagnetischen Abschirmung umfassen. Diese elektrische Isolierung kann bspw. aus einem elektrisch isolierenden Material bestehen, das vorzugsweise elastisch kompressibel ist. Hierdurch können Abweichungen in den Abmessungen zwischen elektromagnetischer Abschirmung und Antriebsstrang-Stromschiene ausgeglichen werden, so dass selbst bei einer Bewegung der Teile zueinander keine Klappergeräusche erzeugt werden.

Grundsätzlich ist es aber auch möglich, die auf der zu der Antriebsstrang-Stromschiene weisenden Seite oder Oberfläche der elektromagnetischen Abschirmung angeordnete elektrische Isolierung, egal ob integriert oder nachträglich angebracht, mit elastisch kompressiblen Bereichen oder Elementen zu versehen, welche aus der Oberfläche hervorstehen. Auf diese Weise muss nicht die gesamte elektrische Isolierung elastisch kompressibel ausgeführt sein, und dennoch wird ein fester Sitz der elektromagnetischen Abschirmung auf der Antriebsstrang-Stromschiene gewährleistet.

### KURZE BESCHREIBUNG DER ZEICHNUNG

Im folgenden Abschnitt soll die Erfindung mit Bezug auf die Zeichnung exemplarisch näher erläutert werden. In der Zeichnung zeigt
- Fig. 1: ein aus dem Stand der Technik bekanntes Verfahren, Leitungen mit einer elektromagnetischen Abschirmung zu versehen,
- Fig. 2: eine Antriebsstrang-Stromschiene mit einer ersten Ausgestaltung der erfindungsgemäßen elektromagnetischen Abschirmung,
- Fig. 3: eine Antriebsstrang-Stromschiene mit einer zweiten Ausgestaltung der erfindungsgemäßen elektromagnetischen Abschirmung,
- Fig. 4: eine weitere Ausgestaltung einer erfindungsgemäßen elektromagnetischen Abschirmung, und
- Fig, 5: ein Flussdiagramm einer Ausgestaltung eines erfindungsgemäßen Verfahrens zur Herstellung einer elektromagnetisch abgeschirmten Antriebsstrang-Stromschiene eines Elektro- oder Hybridfahrzeugs.

In den Figuren der Zeichnung können gleiche oder ähnliche Elemente mit denselben Bezugszeichen bezeichnet sein.

### BESCHREIBUNG VON AUSFÜHRUNGSBEISPIELEN

Figur 1 wurde bereits weiter oben erläutert und wird nicht erneut besprochen.

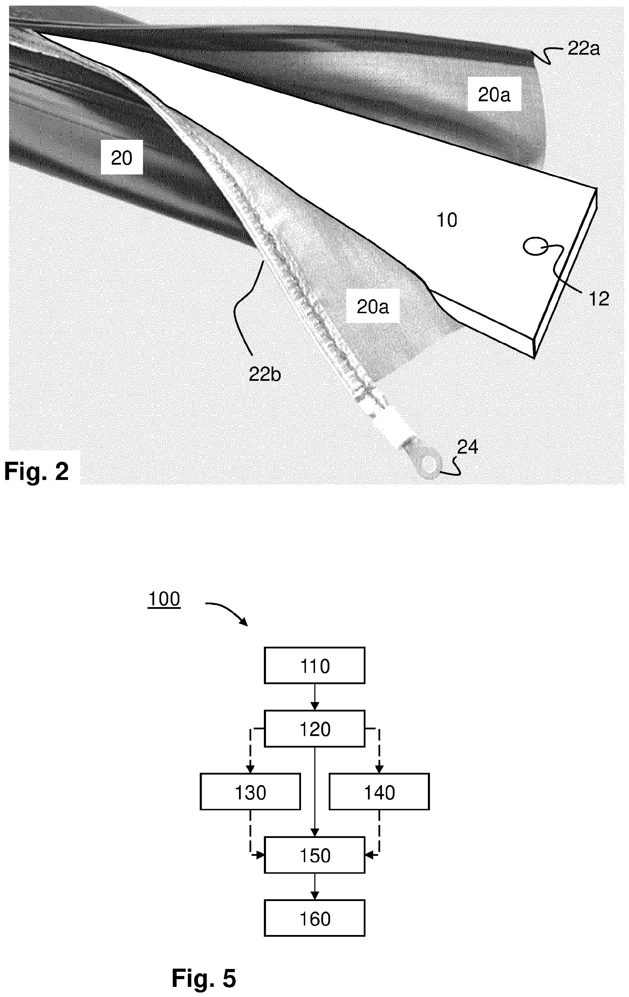

Figur 2 zeigt eine Antriebsstrang-Stromschiene 10 mit einer ersten Ausgestaltung der erfindungsgemäßen elektromagnetischen Abschirmung 20. Die Abschirmung 20 umfasst ein flexibles und/oder elastisches Element, welches eine elektrisch leitende Abschirmschicht aufweist und auf einer zu der Stromschiene 10 weisenden Innenfläche 20a elektrisch isoliert ist. Die Abschirmung 20 weist eine Längserstreckung auf, welche bis zu einer elektrischen Kontaktstelle 12 reicht, an welcher die Stromschiene 10 elektrisch kontaktierbar ist. Die Abschirmung 20 weist eine verschließbare Trennstelle 22 auf, hier durch zwei ineinandergreifende komplementäre Strukturen 22a, 22b gebildet, die eine Art kontinuierlichen Reißverschluss bilden. Eine elektrische Erd- bzw. Masse-Kontaktstelle 24 dient zum Anschluss der Abschirmung an ein Erd- oder Massepotential.

Die vorstehend beschriebene Ausgestaltung kann durch ihre Flexibilität leicht an unterschiedlichste Formen von Stromschienen angepasst werden. Es ist lediglich erforderlich, dass die Abschirmung in einer Dimension quer zu der Längserstreckung ausreichend groß dimensioniert ist, um eine vollständige Umhüllung zu ermöglichen. Es ist jedoch auch möglich, die Abschirmung elastisch auszugestalten, so dass die Dimensionierung quer zu der Längserstreckung so erfolgen kann, dass die Abschirmung eng an der Stromschiene anliegt.

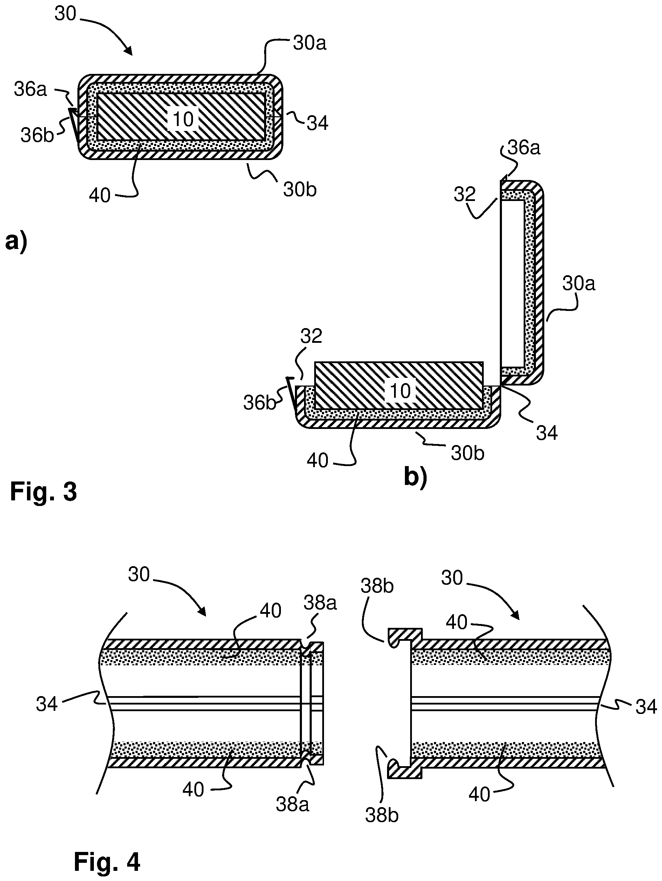

Figur 3 zeigt eine Antriebsstrang-Stromschiene mit 10 einer zweiten Ausgestaltung der erfindungsgemäßen elektromagnetischen Abschirmung 30. Hier ist die Abschirmung durch zwei mittels eines Gelenks oder Scharniers 34 verbundene Hälften 30a und 30b gebildet, welche an einer Trennstelle 32 mittels eines Verschlusses, hier umfassend zwei komplementäre Verschlusskonturen 36a, 36b, verschließbar sind. Die im verschlossenen Zustand aneinanderliegenden Hälften, wie in Figur 3 a) erkennbar, stellen eine elektrische Verbindung zwischen den aus einem elektrisch leitfähigen Material hergestellten Hälften her, genauso wie das Scharnier 34, das hier als Filmscharnier ausgebildet ist. Eine Stromschiene 10 ist im Innern der Abschirmung 30 angeordnet und ist gegenüber dem elektrisch leitfähigen Material der Abschirmung 30 mittels einer elektrisch isolierenden Schicht 40 isoliert. Die elektrisch isolierende Schicht 40 kann elastisch kompressibel ausgestaltet sein oder elastisch kompressible Bereiche aufweisen, so dass die Stromschiene fest in der Abschirmung gelagert ist. Figur 3 b) zeigt die Abschirmung 30 in geöffnetem Zustand.

Figur 4 zeigt eine weitere Ausgestaltung einer erfindungsgemäßen elektromagnetischen Abschirmung 30 in einer Schnittansicht. In der Figur sind zwei Abschirmungen 30 gezeigt, wobei jede der Abschirmungen 30 zwei mittels eines Gelenks oder Scharniers 34 verbundene Halbschalen 30a, 30b 30 aufweist. Ein erstes Ende der in der linken Bildhälfte abgebildeten Abschirmung 30 weist eine erste Verbindungskontur 38a auf, welche komplementär zu einer an einem zweiten Ende der in der rechten Bildhälfte abgebildeten Abschirmung 30 angeordneten zweiten Verbindungskontur 38b ausgestaltet ist. Es ist leicht erkennbar, dass ersten und zweiten Verbindungskonturen 38a, 38b die beiden Abschirmungen 30 miteinander fest verbinden, wenn sie ineinandergreifen. Hierzu kann die zweite Verbindungskontur 38b der in der rechten Bildhälfte abgebildeten Abschirmung 30 zu der ersten Verbindungskontur 38a der in der linken Bildhälfte sichtbaren Abschirmung 30 ausgerichtet werden, bevor die in der rechten Bildhälfte abgebildete Abschirmung 30 geschlossen wird. Die durchgehende elektromagnetische Abschirmung kann bspw. dadurch gewährleistet sein, dass das Material der Abschirmung elektrisch leitend ist, so dass die Verbindung zugleich mechanisch und elektrisch leitend erfolgt. Zur elektrischen Isolierung einer in der Abschirmung angeordneten Stromschiene (nicht in der Figur gezeigt) gegenüber der Abschirmung 30 dient eine elektrisch isolierende Schicht 40.

Figur 5 zeigt ein Flussdiagramm einer Ausgestaltung eines erfindungsgemäßen Verfahrens 100 zur Herstellung einer elektromagnetisch abgeschirmten Antriebsstrang-Stromschiene 10 eines Elektro- oder Hybridfahrzeugs. In Schritt 110 wird eine in ihrer Form an deren Einbauort angepassten Stromschiene 10 bereitgestellt, und in Schritt 120 ein oder mehrere Teile einer in der Gesamtheit der Teile in zumindest einer Dimension an die Stromschiene angepassten elektromagnetischen Abschirmung 20, 30. Sofern die Stromschiene oder die Abschirmung an ihrer zu der Stromschiene weisenden Oberfläche nicht elektrisch isoliert sind, kann in einem optionalen Schritt 130 die Stromschiene mit einer an dieser eng anliegenden elektrischen Isolierung umhüllt werden, oder in Schritt 140 eine elektrische Isolierung auf der zu der Stromschiene weisenden Seite oder Oberfläche der elektromagnetischen Abschirmung angebracht werden. In Schritt 150 wird die Stromschiene in der elektromagnetischen Abschirmung angeordnet, und in Schritt 160 wird die elektromagnetische Abschirmung verschlossen. Die solcherart hergestellte elektromagnetisch abgeschirmte Stromschiene kann nun an dem vorgesehen Einbauort verbaut und elektrisch angeschlossen werden.

### Liste der Bezugszeichen (Teil der Beschreibung)

- 10: Antriebsstrang-Stromschiene
- 12: elektrische Kontaktstelle
- 20: Abschirmung
- 20a: Innenfläche
- 22: Trennstelle
- 24: elektrische Erd-/Masse-Kontaktstelle
- 30: Abschirmung
- 32: Trennstelle
- 34: Scharnier/Gelenk
- 36a: Verschlusskontur
- 36b: Verschlusskontur
- 38a: erste Verbindungskontur
- 38b: zweite Verbindungskontur
- 40: elektrisch isolierende Schicht
- 60: Einzelleiterbündel
- 70: EMI-Band
- 100: Verfahren
- 110: Bereitstellen Stromschiene
- 120: Bereitstellen Abschirmung
- 130: Isolierung Stromschiene
- 140: Anbringen Isolierung an der Abschirmung
- 150: Umhüllen
- 160: Verschließen der Trennstelle

## Patentansprüche

1. Elektromagnetische Abschirmung einer starren, formstabilen Antriebsstrang-Stromschiene (10) eines Elektro- oder Hybridfahrzeugs umfassend zumindest ein ein- oder mehrteiliges, an die Form bzw. Kontur der Antriebsstrang-Stromschiene (10) angepasstes Abschirmelement (20, 30), wobei das zumindest eine Abschirmelement eine elektrisch leitfähige Schicht aufweist, wobei das zumindest eine Abschirmelement (20, 30) auf einer zu der Antriebsstrang-Stromschiene (10) weisenden Seite elektrisch nichtleitend ist, mit einer elektrisch isolierenden Schicht versehen ist, oder zur Aufnahme einer elektrisch isolierenden Schicht eingerichtet ist, und wobei das ein- oder mehrteilige Abschirmelement (20,30) mindestens eine verschließbare Trennstelle (22, 32) aufweist, an welcher ein Zugang zu einem von dem ein- oder mehrteiligen Abschirmelement (20, 30) umschlossenen Raum ermöglicht ist, um das Abschirmelement (20, 30) um die Antriebsstrang-Stromschiene (10) herum anzuordnen.

2. Elektromagnetische Abschirmung nach Anspruch 1, wobei zumindest ein Abschirmelement (20, 30) zumindest an einem Ende entlang der Kontur der von der Abschirmung umschlossenen Antriebsstrang-Stromschiene (10) eine erste Verbindungskontur (38a) aufweist, welche zur formschlüssigen Aufnahme einer komplementären zweiten Verbindungskontur (38b) eines weiteren Abschirmelements (20, 30) eingerichtet ist, und welche außerdem dazu eingerichtet ist, eine elektrisch leitfähige Verbindung zwischen den beiden Abschirmelementen (20, 30) herzustellen.

3. Elektromagnetische Abschirmung nach Anspruch 1 oder 2, wobei eine mit der Abschirmung fest verbundene oder darin integrierte elektrische Kontaktstelle (24) vorgesehen ist, welche zur Kontaktierung der Abschirmung mit einem Masse- oder Erdpotential eingerichtet ist.

4. Elektromagnetische Abschirmung nach Anspruch 3, wobei die Abschirmung neben der elektrische Kontaktstelle (24) eine oder mehrere Befestigungsstrukturen aufweist, welche elektrisch isoliert oder zur Kontaktierung mit einem Masse- oder Erdpotential eingerichtet sind.

5. Elektromagnetische Abschirmung nach einem der Ansprüche 1 bis 5, wobei an der mindestens einen verschließbaren Trennstelle (22, 32) zusammenwirkende Verbindungselemente (36a, 36b) vorgesehen sind, welche die Trennstelle (22, 32) im verschlossenen Zustand halten.

6. Elektromagnetische Abschirmung nach einem der Ansprüche 1 bis 5, wobei auf einer zu der Antriebsstrang-Stromschiene (10) weisenden Oberfläche (20a) der Abschirmung eine elektrisch nichtleitende, elastisch kompressible Schicht (40) oder aus der Oberfläche vorstehende, elektrisch nichtleitende, elastisch kompressible Elemente oder Bereiche angeordnet sind.

7. Verfahren (100) zur Herstellung einer elektromagnetisch abgeschirmten Antriebsstrang-Stromschiene (10) eines Elektro- oder Hybridfahrzeugs, umfassend:
- Bereitstellen (110) einer in ihrer Form an deren Einbauort angepassten Stromschiene (10),
- Bereitstellen (120) eines oder mehrerer Teile einer in der Gesamtheit der Teile in zumindest einer Dimension an die Stromschiene angepassten elektromagnetischen Abschirmung (20, 30) nach einem der Ansprüche 1 bis 5,
- Anordnen (150) der Stromschiene (10) in der elektromagnetischen Abschirmung (20, 30), und
- Verschließen (160) der Trennstelle (22, 32).

8. Verfahren (100) nach Anspruch 7, außerdem umfassend, wenn weder die Antriebsstrang-Stromschiene noch die elektromagnetische Abschirmung auf ihrer zu der Antriebsstrang-Stromschiene weisenden Seite oder Oberfläche elektrisch isoliert sind:
- Umhüllen (130) der Antriebsstrang-Stromschiene (10) mit einer an dieser eng anliegenden elektrischen Isolierung,
oder
- Anbringen (140) einer elektrischen Isolierung auf der zu der Antriebsstrang-Stromschiene (10) weisenden Seite oder Oberfläche der elektromagnetischen Abschirmung,
vor dem Anordnen (150).
